# EUROPEAN PATENT APPLICATION

(11) **EP 3 470 956 A1**
(43) Date of publication of application: **17.04.2019**
(21) Application number: 18151381.3
(22) Date of filing: 12.01.2018
(51) Int. Cl.: G06F 1/20

(54) **DYNAMICALLY ADJUST MAXIMUM FAN DUTY IN A SERVER SYSTEM**

(30) Priority: 12.10.2017 US 201715730948
(71) Applicant: Quanta Computer Inc., Taoyuan City 33377 (TW)
(72) Inventor: CHEN, Chao-Jung, 33377 Taoyuan City (TW); CHEN, Yi-Chieh, 33377 Taoyuan City (TW); CHEN, Jen-Mao, 33377 Taoyuan City (TW); KU, Kai-Fan, 33377 Taoyuan City (TW)
(74) Representative: Krauns, Christian

(57) **Abstract**

The present disclosure provides a system and method for dynamically adjusting maximum fan duties in a server system. In accordance with one aspect of the present disclosure, a computer-implemented method for dynamically adjusting maximum fan duties in the server system, comprises: powering on the server system; receiving, from BIOS, bus interface information of a system board of the server system; determining that there is no rotation-vibration issues (RVI) sensitive device directly connected to the system board; and setting a first maximum fan duty for one or more cooling fans of the server system.

## Description

### FIELD OF THE INVENTION

The present disclosure generally relates to cooling in a computing system.

### BACKGROUND

Ever shrinking transistor sizes lead to dramatically increased densities and temperatures inside server systems. Modern server farms or datacenters typically employ a number of server systems to handle processing and storage needs for a variety of application services. To protect components inside the server systems, cooling becomes more challenging than ever. To keep adequate cooling inside server systems, cooling fans often have to operate at very high fan speeds. For example, a maximum rotation per minute (RPM) of "4056-type high speed fans" and "6056-type high speed fans" can reach 24,000-25,000 RPM and 18,000-19,000 RPM, respectively.

As fan RPM increases, hard drive (HDD) performance inside server systems can be impacted due to rotation-vibration issues (RVI). For example, a modern HDD spins at up to 15,000 RPM with the read/write head only several nanometers away. Any vibrational disturbance to the HDD may cause one or multiple sequences of read-retries and write-retries and, hence decreases the HDD performance.

One conventional solution is to introduce solid state drives (SSDs) inside server systems. SSDs are made of flash integrated circuits (ICs) and have no motor inside. Thus, SSDs are not RVI sensitive devices. However, SSDs are much more expensive than traditional HDDs.

Further, even with SSDs replacing some or all of the HDDs, it remains a challenge to provide efficient cooling inside server systems.

### SUMMARY

Systems and methods in accordance with various examples of the present disclosure provide a solution to the above-mentioned problems by dynamically adjusting maximum fan duties in a server system. In some examples, upon the server system being powered on, a Basic Input/Output System (BIOS) can provide bus interface information of a system board of the server system to a management controller of the server system. The management controller can be a baseboard management controller (BMC) or a rack management controller (RMC). The management controller can further determine whether any Host Bus Adapter (HBA) card or Redundant Array of Independent Disk (RAID) card is directly connected to the system board, and then dynamically set maximum fan duties for cooling fan(s) of the server system.

In accordance with one aspect of the present disclosure, a computer-implemented method for dynamically adjusting maximum fan duties in a server system, comprises: powering on the server system; receiving, from the BIOS, bus interface information of a system board of the server system; determining that there is no Rotation-Vibration Issues (RVI) sensitive device (e.g., a hard drive (HDD)) directly connected to the system board; determining that there is no HBA card or RAID card directly connected to the system board; and setting a first maximum fan duty for one or more cooling fans of the server system.

In some examples, the computer-implemented method further comprises: determining that there is at least one RVI sensitive device directly connected to the system board; and setting a second maximum fan duty for cooling fan(s) of the server system. The second maximum fan duty is smaller than the first maximum fan duty, and is a highest fan duty that is limited by RVI of a corresponding type of the at least one RVI sensitive device (e.g., HDD).

In some examples, the management controller of the server system can further set the second maximum fan duty for cooling fan(s) of the server system, based at least upon a sensitivity level of the type of the at least one RVI sensitive device. For example, if the type of the at least one RVI sensitive device is more sensitive to RVI, the management device can set the second maximum fan duty to a lower value accordingly. In some implementations, the management controller may determine a corresponding location of the at least one RVI sensitive device, and a relative position between the at least one RVI sensitive device and the cooling fan(s). The management controller may further adjust the second maximum fan duty for cooling fan(s) of the server system, based upon the relative position between the at least one RVI sensitive device and the cooling fan(s).

In some examples, the computer-implemented method further comprises: determining that there is at least one HBA card or RAID card directly connected to the system board; and determining whether there is any RVI sensitive device connected to the at least one HBA card or RAID card. In an event that there is no RVI sensitive device attached to the at least one HBA card or RAID card, the management controller can set the first maximum fan duty for the one or more cooling fans of the server system. In an event that there is at least one RVI sensitive device attached to the at least one HBA card or RAID card, the management controller can set the second maximum fan duty for the one or more cooling fans of the server system.

In some examples, the management controller determines whether there is any RVI sensitive device connected to the at least one HBA card or RAID card based upon device information provided by the BIOS. The device information includes, but is not limited to, Device ID, sub Device ID, vendor ID, and sub vendor ID. The management controller can determine whether there is any RVI sensitive device connected to the at least one HBA card or RAID card based at least upon the device information from the BIOS.

In some examples, the management controller determines whether there is any RVI sensitive device (e.g., a HDD) directly connected to a system board in a server system based upon information defined in the operating system of the server system. For example, if the server system is running Windows 7 operating system, the management device can determine whether a HDD is directly connected to the system board using ATA8-ACS identify word 217. The value of a traditional motor HDD is in a range of 0401h-FFFEh.

In some examples, the system board is a field-replaceable unit (FRU) that can accommodate at least one RVI sensitive device (e.g., a HDD) and at least one SSD. The system board is configured such that the at least one RVI sensitive device, the at least one SSD, or another component of the server system can be quickly and easily removed or installed onto the server system.

In some examples, a bus interface of the system board comprises, but is not limited to, Serial At Attachment (SATA), Parallel ATA (PATA), Small Computer System Interface (SCSI), Serial Attached SCSI (SAS), and Fibre Channel (FC).

In accordance with another aspect of the present disclosure, a non-transitory computer-readable storage medium storing instructions is provided. When the instructions are executed by a processor, they cause the processor to perform operations that include: powering on a server system; receiving, from BIOS, bus interface information of a system board of the server system; determining that there is no RVI sensitive device (e.g., HDD) directly connected to the system board; determining that there is no HBA card or RAID card directly connected to the system board; and setting a first maximum fan duty for one or more cooling fans of the server system.

Additional features and advantages of the disclosure will be set forth in the description which follows, and in part, will be obvious from the description, or can be learned by practice of the herein disclosed principles. The features and advantages of the disclosure can be realized and obtained by means of the instruments and combinations particularly pointed out in the appended claims. These and other features of the disclosure will become more fully apparent from the following description and appended claims, or can be learned by the practice of the principles set forth herein.

### BRIEF DESCRIPTION OF THE DRAWINGS

In order to describe the manner in which the above-recited and other advantages and features of the disclosure can be obtained, a more particular description of the principles briefly described above will be rendered by reference to specific examples thereof which are illustrated in the appended drawings. These drawings depict only example aspects of the disclosure and are not therefore to be considered to be limiting of its scope. The principles herein are described and explained with additional specificity and detail through the use of the accompanying drawings in which:
FIG. 1 is a schematic block diagram illustrating an exemplary system in a datacenter for dynamically adjusting maximum fan duties, in accordance with an implementation of the present disclosure;
FIG. 2 is an exemplary method for dynamically adjusting maximum fan duties in a server system, in accordance with an implementation of the present disclosure;
FIG. 3 illustrates an exemplary computing device in accordance with various implementations of the disclosure; and
FIGS. 4 and 5 illustrate exemplary systems in accordance with various examples of the present disclosure.

### DETAILED DESCRIPTION

The present disclosure can be embodied in many different forms. Representative embodiments are shown in the drawings, and will herein be described in detail, with the understanding that the present disclosure is an example or illustration of the principles of the present disclosure, and is not intended to limit the broad aspects of the disclosure to the embodiments illustrated. To that extent, elements and limitations that are disclosed, for example, in the Abstract, Summary, and Detailed Description sections, but not explicitly set forth in the claims, should not be incorporated into the claims, singly or collectively, by implication, inference, or otherwise. For purposes of the present detailed description, unless specifically disclaimed: the singular includes the plural and vice versa; and the word "including" means "including without limitation." Moreover, words of approximation, such as "about," "almost," "substantially," "approximately," and the like, can be used herein to mean "at, near, or nearly at," or "within 3-5% of," or "within acceptable manufacturing tolerances," or any logical combination thereof, for example.

Various examples of the present disclosure provide methods for dynamically adjusting maximum fan duties in a server system and systems therefrom. In some examples, upon the server system being powered on, a Basic Input/Output System (BIOS) can provide bus interface information of a system board of the server system to a management controller of the server system. The management controller can further determine whether any Host Bus Adapter (HBA) card or Redundant Array of Independent Disk (RAID) card is directly connected to the system board. Thereafter, the management controller can dynamically set maximum fan duties for one or more cooling fans of the server system.

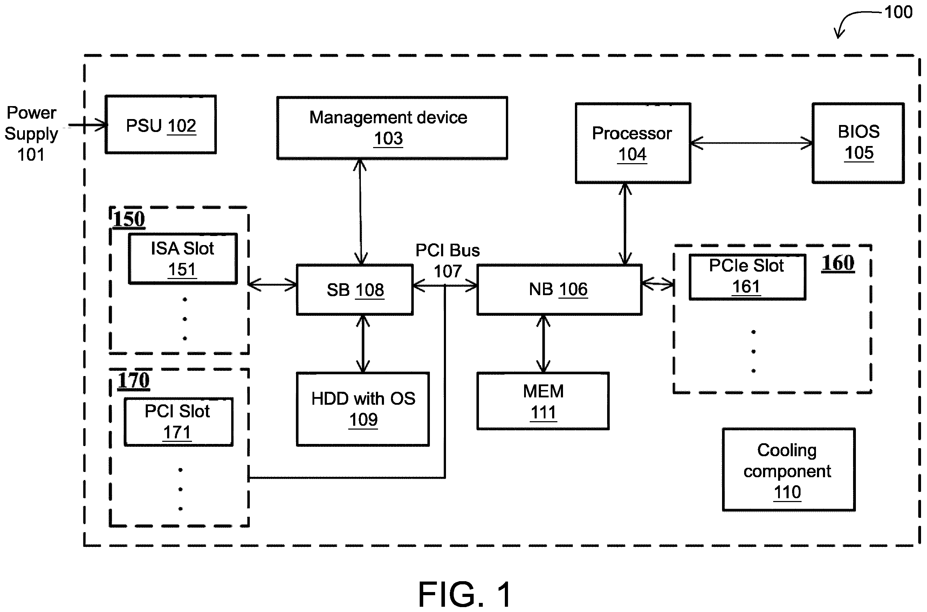

FIG. 1 is a schematic block diagram illustrating an exemplary server system 100 configured to dynamically adjusting maximum fan duties, in accordance with an implementation of the present disclosure. In this example, the server system 100 includes at least one microprocessor or processor 104, one or more cooling components 110, a main memory (MEM) 111, at least one power supply unit (PSU) 102 that receives an AC power from an AC power supply 101 and supply power to various components of the server system 100, such as the processor 104, north bridge (NB) logic 106, PCIe slots 160, south bridge (SB) logic 108, storage device 109, ISA slots 150, PCI slots 170, and a management device 103. After being powered on, the server system 100 is configured to load software application from memory, computer storage device, or an external storage device to perform various operations. The storage device 109 is structured into logical blocks that are available to an operating system, and applications of the server system 100. The storage device 109 is configured to retain server data, even when the server system 100 is powered off.

In this example, the BIOS 105 can be any program instructions or firmware configured to initiate and identify various components of the server system 100. The BIOS is an important system component that is responsible for initializing and testing hardware components of a corresponding server system. The BIOS can provide an abstraction layer for the hardware components, thereby providing a consistent way for applications and operating systems to interact with a peripheral device such as a keyboard, a display, and other input/output devices.

In some configurations, the BIOS 105 can run a system check prior to booting up an operating system (OS), e.g., the Microsoft Windows® OS, the Linux® OS, or any operating system, on the server system 100. The system check is a diagnostic system examination executed during initialization of the server system 100. An example of system check includes a Power-On Self-Test (POST). The BIOS can handle major functions of POST, and may offload some duties to other programs designed to initialize specific peripheral devices (e.g., video and small computer system interface (SCSI) initialization). The major functions of POST may include: verifying CPU registers and the integrity of the BIOS code; checking basic components; examining system main memory; and passing control to other specialized BIOS extension. In some configurations, the BIOS may also handle additional POSTs functions including: discovering, initializing, and cataloging all system buses and devices, providing a user interface for updating system's configuration, and constructing a system environment required by the operating system.

The management device 103 (e.g., BMC or RMC) can communicate with processor 104 and storage device 111. In one example, this communication can occur via Intelligent Platform Management Interface (IPMI) messages using a system bus (e.g., Intelligent Platform Management Bus/Bridge (IPMB)). IPMB is an enhanced implementation of inter-integrated circuit (PC) bus and is a message-based, hardware-level basic interface specification. However, the present disclosure contemplates that other communication types can be used between the management device 103 and other components.

In this example, the one or more cooling components 110 are configured to cool down components of the server system 100. The one or more cooling components 110 comprise at least one cooling fan. Speeds of the at least one cooling fan correspond to fan duties that are set by the management device 103. In some implementations, the cooling components 110 may further comprise a pump, a radiator and liquid coolant (e.g., water).

In some examples, the management device 103 or the BIOS 105 can determine whether a HDD or a SSD is directly connected to a system board of the server system 100, based upon information defined in the operating system of the server system 100. For example, if the server system is running Windows 7 operating system, the management device 103, or the BIOS 105 can determine whether a HDD or SDD is directly connected to the system board using "ATA8-ACS identify Word 217." The value of a traditional motor HDD is in a range of "0401h-FFFEh." The value of a SSD is "0001h." Table 1 illustrates an exemplary nominal media rotation rate defined in the Windows 7 operating system, in accordance with an implementation of the present disclosure.

**Table 1: Nominal Media Rotation Rate**

| Value | Description |
|---|---|
| 000h | Rate not reported |
| 0001h | Non-rotating media (e.g., solid state device) |
| 0002h-0400h | Reserved |
| 0401h-FFFEh | Nominal media rotation rate in rotation per minute (RPM) (e.g., 7200 RPM = 1C20h) |
| FFFFh | Reserved |

In some examples, a system board of the server system is a FRU that can accommodate a plurality of HDDs and a plurality of SSDs. The system board is configured such that the plurality of HDDs and the plurality of SSDs can be quickly and easily removed or installed onto the server system 100.

In FIG. 1, the memory 111 is coupled to the processor 104 via the NB logic 106. The memory 111 may include, but is not limited to, dynamic random access memory (DRAM), double data rate DRAM (DDR DRAM), static RAM (SRAM), or other types of suitable memory. The memory 111 can be configured to store BIOS data of the server system 100. In some configurations, BIOS data can be stored on the storage device 109.

In some implementations, the server system 100 can further comprise a flash storage device. The flash storage device can be a flash drive, a random access memory (RAM), a non-volatile random-access memory (NVRAM), or an electrically erasable programmable read-only memory (EEPROM). The flash storage device can be configured to store the system configurations such as BIOS data.

The processor 104 can be a central processing unit (CPU) configured to execute program instructions for specific functions. For example, during a booting process, the processor 104 can access BIOS data stored in the management device 103 or the flash storage device, and execute the BIOS 105 to initialize the server system 104. After the booting process, the processor 104 can execute an operating system in order to perform and manage specific tasks for the server system 100.

In some implementations, the management device 103 can determine that the operating system on the server system 100 has been updated; determine whether a firmware update (e.g., update of nominal media rotation rate) is available; and automatically download the firmware update from a corresponding vendor. In some examples, the management controller can monitor availability of firmware updates (e.g., updates of nominal media rotation rate) by communicating with a central management server, and download latest firmware updates whenever the updates become available. In some examples, the management controller can receive the firmware updates out-of-band when the server system 100 is not in operation, or even when the server system is powered off.

In some configurations, the processor 104 can be multi-core processors, each of which is coupled together through a CPU bus connected to the NB logic 106. In some configurations, the NB logic 106 can be integrated into the processor 104. The NB logic 106 can also be connected to a plurality of peripheral component interconnect express (PCIe) slots 160 and an SB logic 108 (optional). The plurality of PCIe slots 160 can be used for connections and buses such as PCI Express x1, USB 2.0, SMBus, SIM card, future extension for another PCIe lane, 1.5 V and 3.3 V power, and wires to diagnostics LEDs on the server system 100's chassis.

In system 100, the NB logic 106 and the SB logic 108 are connected by a peripheral component interconnect (PCI) Bus 107. The PCI Bus 107 can support function on the processor 104, but in a standardized format that is independent of any of the processor 104's native buses. The PCI Bus 107 can be further connected to a plurality of PCI slots 170 (e.g., a PCI slot 171). Devices connect to the PCI Bus 107 may act as a bus controller (not shown) to be connected directly to a CPU bus, assigned addresses in the processor 104's address space, and synchronized to a single bus clock. PCI cards that can be used in the plurality of PCI slots 170 include, but are not limited to, network interface cards (NICs), sound cards, modems, TV tuner cards, disk controllers, video cards, small computer system interface (SCSI) adapters, and personal computer memory card international association (PCMCIA) cards.

The SB logic 108 can couple the PCI Bus 107 to a plurality of expansion cards or ISA slots 150 (e.g., an ISA slot 151) via an expansion bus. The expansion bus can be a bus used for communications between the SB logic 108 and peripheral devices, and may include, but is not limited to, an industry standard architecture (ISA) bus, PC/104 bus, low pin count bus, extended ISA (EISA) bus, universal serial bus (USB), integrated drive electronics (IDE) bus, or any other suitable bus that can be used for data communications for peripheral devices.

In system 100, the SB logic 108 is further coupled to a management device 103 that is connected to the at least one PSU 102. In some implementations, the management device 103 can be a baseboard management controller (BMC), rack management controller (RMC), or any other suitable type of system controller. The management device 103 can be configured to receive firmware update by communicating with a computing device or user device via a network.

Although only certain components are shown within the exemplary system 100 in FIG. 1, various types of electronic or computing components that are capable of processing or storing data, receiving or transmitting signals, or providing fresh air to downstream components, can also be included in the exemplary systems 100. Further, the electronic or computing components in the exemplary system 100 can be configured to execute various types of application and/or can use various types of operating systems. These operating systems can include, but are not limited to, Android, Berkeley Software Distribution (BSD), iPhone OS (iOS), Linux, OS X, Unix-like Real-time Operating System (e.g., QNX), Microsoft Windows, Window Phone, and IBM z/OS.

Depending on the desired implementation for the exemplary system 100, a variety of networking and messaging protocols can be used, including but not limited to TCP/IP, open systems interconnection (OSI), file transfer protocol (FTP), universal plug and play (UpnP), network file system (NFS), common internet file system (CIFS), AppleTalk etc. As would be appreciated by those skilled in the art, the exemplary system 100 illustrated in FIG. 1 is used for purposes of explanation. Therefore, a network system can be implemented with many variations, as appropriate, yet still provide a configuration of network platform in accordance with various examples of the present disclosure.

In exemplary configuration of FIG. 1, the exemplary system 100 can also include one or more wireless components operable to communicate with one or more electronic devices within a computing range of the particular wireless channel. The wireless channel can be any appropriate channel used to enable devices to communicate wirelessly, such as Bluetooth, cellular, NFC, or Wi-Fi channels. It should be understood that the device can have one or more conventional wired communications connections, as known in the art. Various other elements and/or combinations are possible as well within the scope of various examples.

The above discussion is meant to be illustrative of the principles and various examples of the present disclosure. Numerous variations and modifications will become apparent once the above disclosure is fully appreciated.

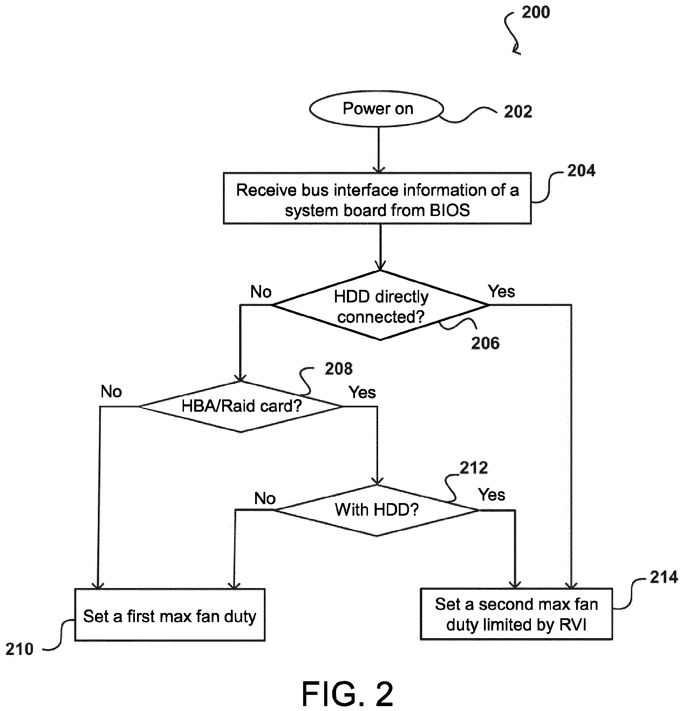

FIG. 2 is an exemplary method for dynamically adjusting maximum fan duties in a server system, in accordance with an implementation of the present disclosure. It should be understood that the exemplary method 200 is presented solely for illustrative purposes, and that in other methods in accordance with the present disclosure can include additional, fewer, or alternative steps performed in similar or alternative orders, or in parallel. The exemplary method 200 starts at step 202 by powering on the server system.

At step 204, a management controller of the server system can receive from BIOS bus interface information (e.g., onboard HDD types) of a system board of the server system, as illustrated in FIG. 1. The bus interface information can be sent by a BIOS of the server system during power on. The system board is a field-replaceable unit (FRU) that can accommodate at least one HDD and at least one SSD; and is configured such that the at least one HDD, and the at least one SSD, can be quickly and easily removed or installed onto the server system. A bus interface of the system board comprises, but is not limited to, Serial At Attachment (SATA), Parallel ATA (PATA), Small Computer System Interface (SCSI), Serial Attached SCSI (SAS), and Fibre Channel (FC).

In some examples, the BIOS can scan all system devices and identify whether the server system has at least one storage device. In an event that the server system has at least one storage device, the BIOS can inquiry a register of the server system to determine whether the at least one storage device is a rotating media.

At step 206, the management controller can determine whether there is any HDD directly connected to the system board. In some examples, the management controller determines whether there is any HDD directly connected to the system board, based upon information defined in the operating system running of the server system.

In an event that there is no HDD directly connected to the system board, the management controller can further determine whether there is any HBA card or RAID card directly connected to the system board, at step 208. In an event that there is no HBA card or RAID card directly connected to the system board, the management controller can set a first maximum fan duty for cooling fan(s) of the server system, at step 210. In some implementations, the first maximum fan duty can be a full speed recommended by the manufacturer for the one or more cooling fans. In other implementations, the first maximum fan duty can be a full speed lower or higher than the full speed recommended by the manufacturer.

At step 212, in an event that there is at least one HBA card or RAID card directly connected to the system board, the management controller can also determine whether there is any HDD directly connected to the at least one HBA card or RAID card. In an event that there is no HDD directly connected to the at least one HBA card or RAID card, the method proceeds to step 210 where the management controller can set the first maximum fan duty for the one or more cooling fans of the server system.

In an event that there is at least one HDD directly connected to the system board, or the at least one HBA card or RAID card, the method proceeds to step 214. At step 214, the management controller can set a second maximum fan duty for the one or more cooling fans of the server system. The second maximum fan duty is smaller than the first maximum fan duty and is a highest fan duty that is limited by RVI of a corresponding type of the at least one HDD. The exemplary method 200 goes back to step 202 in an event that any of the at least one HDD or at least one SSD is removed or installed onto the system board of the server system.

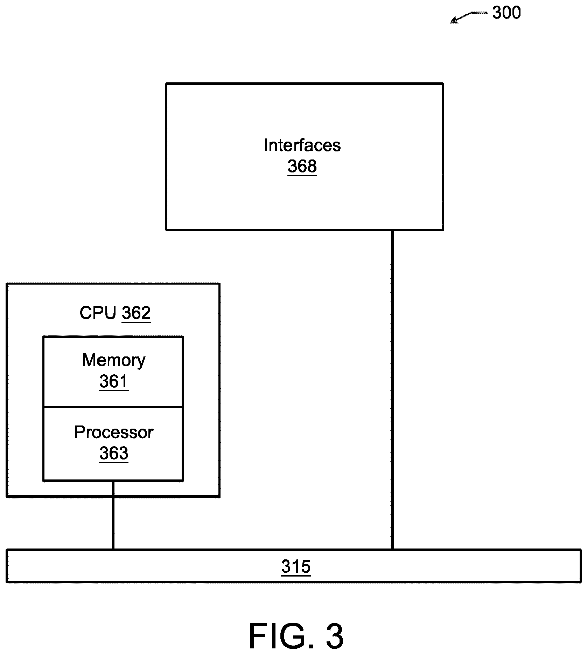

A brief introductory description of example systems and networks, as illustrated in FIGs. 3-5, is disclosed herein. These variations shall be described herein as the various examples are set forth. The present disclosure now turns to FIG. 3.

FIG. 3 illustrates an example computing device 300 suitable for implementing the present disclosure. Computing device 300 includes a master central processing unit (CPU) 362, interfaces 368, and a bus 315 (*e.g.*, a PCI bus). When acting under the control of appropriate software or firmware, the CPU 362 is responsible for executing packet management, error detection, and/or routing functions, such as miscabling detection functions, for example. The CPU 362 preferably accomplishes all these functions under the control of software, including an operating system and any appropriate applications software. CPU 362 can include one or more processors 363 such as a processor from the Motorola family of microprocessors, or the MIPS family of microprocessors. In an alternative example, processor 363 is specially designed hardware for controlling the operations of the computing device 300. In a specific example, a memory 361 (such as non-volatile RAM and/or ROM) also forms part of CPU 362. However, there are many different ways in which memory could be coupled to the system.

The interfaces 368 are typically provided as interface cards (sometimes referred to as "line cards"). Generally, they control the sending and receiving of data packets over the network and sometimes support other peripherals used with the computing device 300. Among the interfaces that can be provided are Ethernet interfaces, frame relay interfaces, cable interfaces, DSL interfaces, token ring interfaces, and the like. In addition, various very high-speed interfaces can be provided such as fast token ring interfaces, wireless interfaces, Ethernet interfaces, Gigabit Ethernet interfaces, ATM interfaces, HSSI interfaces, POS interfaces, FDDI interfaces and the like. Generally, these interfaces can include ports appropriate for communication with the appropriate media. In some cases, they can also include an independent processor and, in some instances, volatile RAM. The independent processors can control such communications intensive tasks as packet switching, media control, and management. By providing separate processors for the communications intensive tasks, these interfaces allow the master microprocessor 362 to efficiently perform routing computations, network diagnostics, security functions, etc.

Although the system shown in FIG. 3 is one specific computing device of the present disclosure, it is by no means the only network device architecture on which the present patent application can be implemented. For example, an architecture having a single processor that handles communications as well as routing computations, etc. is often used. Further, other types of interfaces and media could also be used with the router.

Regardless of the network device's configuration, it can employ one or more memories or memory modules (including memory 361) configured to store program instructions for the general-purpose network operations and mechanisms for roaming, route optimization and routing functions described herein. The program instructions can control the operation of an operating system and/or one or more applications, for example. The memory or memories can also be configured to store tables such as mobility binding, registration, and association tables, etc.

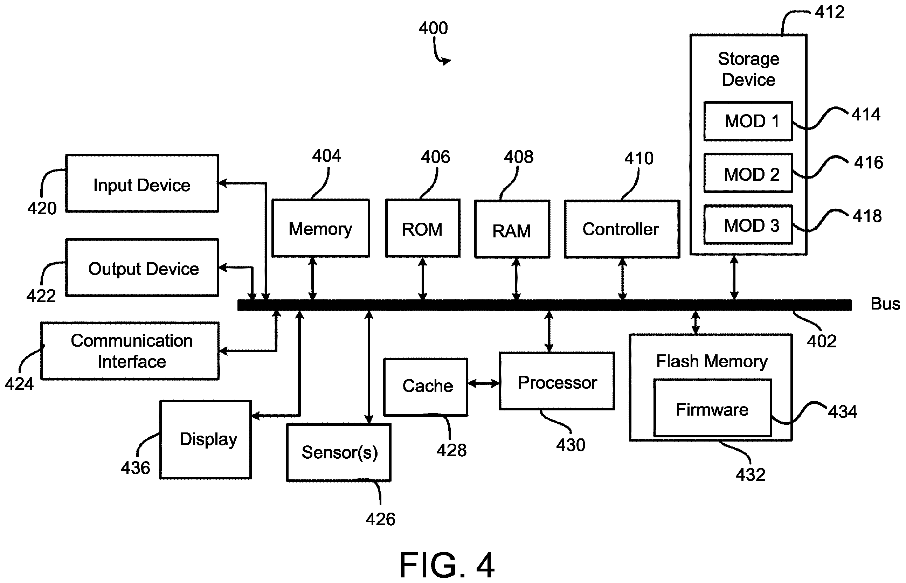

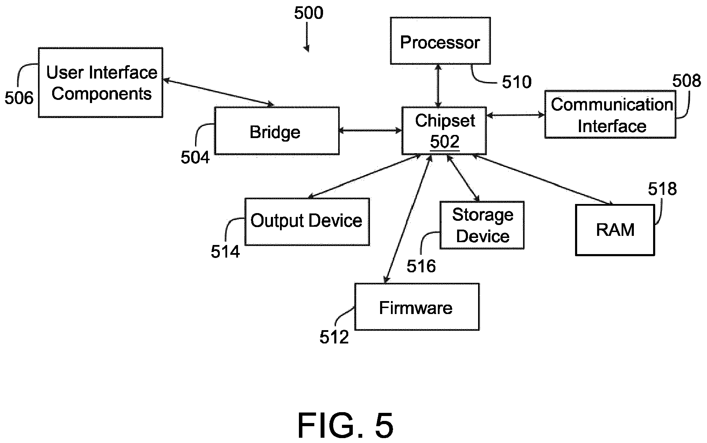

FIGs. 4 and 5 illustrate example system embodiments. The more appropriate embodiment will be apparent to those of ordinary skill in the art when practicing the present disclosure. Persons of ordinary skill in the art will also readily appreciate that other system embodiments are possible.

FIG. 4 illustrates a system bus computing system architecture 400 wherein the components of the system are in electrical communication with each other using a bus 402. Example system 400 includes a processing unit (CPU or processor) 430 and a system bus 402, that couples various system components including the system memory 404, such as read only memory (ROM) 406 and random access memory (RAM) 408, to the processor 430. The system 400 can include a cache of high-speed memory connected directly with, in close proximity to, or integrated as part of the processor 430. The system 400 can copy data from the memory 404 and/or the storage device 412 to the cache 428 for quick access by the processor 430. In this way, the cache can provide a performance boost that avoids processor 430 delays while waiting for data. These and other modules can control or be configured to control the processor 430 to perform various actions. Other system memory 404 may be available for use as well. The memory 404 can include multiple different types of memory with different performance characteristics. The processor 430 can include any general purpose processor and a hardware module or software module, such as module 1 414, module 2 416, and module 3 418 stored in storage device 412, configured to control the processor 430, as well as a special-purpose processor where software instructions are incorporated into the actual processor design. The processor 430 may essentially be a completely self-contained computing system, containing multiple cores or processors, a bus, memory controller, cache, etc. A multi-core processor may be symmetric or asymmetric.

To enable user interaction with the computing device 400, an input device 420 can represent any number of input mechanisms, such as a microphone for speech, a touch-sensitive screen for gesture or graphical input, keyboard, mouse, motion input, and so forth. An output device 422 can also be one or more of a number of output mechanisms known to those of skill in the art. In some instances, multimodal systems can enable a user to provide multiple types of input to communicate with the system 400. The communications interface 424 can generally govern and manage the user input and system output. There is no restriction on operating on any particular hardware arrangement, and therefore the basic features here may easily be substituted for improved hardware or firmware arrangements as they are developed.

Storage device 412 is a non-volatile memory and can be a hard disk or other types of computer readable media which can store data that are accessible by a computer, such as magnetic cassettes, flash memory cards, solid state memory devices, digital versatile disks, cartridges, random access memories (RAMs) 408, read only memory (ROM) 406, and hybrids thereof.

The storage device 412 can include software modules 414, 416, 418 for controlling the processor 430. Other hardware or software modules are contemplated. The storage device 412 can be connected to the system bus 402. In one aspect, a hardware module that performs a particular function can include the software component stored in a computer-readable medium in connection with the necessary hardware components, such as the processor 430, bus 402, display 436, and so forth, to carry out the function.

The controller 410 can be a specialized microcontroller or processor on the system 400, such as a BMC (baseboard management controller). In some cases, the controller 410 can be part of an Intelligent Platform Management Interface (IPMI). Moreover, in some cases, the controller 410 can be embedded on a motherboard or main circuit board of the system 400. The controller 410 can manage the interface between system management software and platform hardware. The controller 410 can also communicate with various system devices and components (internal and/or external), such as controllers or peripheral components, as further described below.

The controller 410 can generate specific responses to notifications, alerts, and/or events, and communicate with remote devices or components (e.g., electronic mail message, network message, etc.) to generate an instruction or command for automatic hardware recovery procedures, etc. An administrator can also remotely communicate with the controller 410 to initiate or conduct specific hardware recovery procedures or operations, as further described below.

Different types of sensors (e.g., sensors 426) on the system 400 can report to the controller 410 on parameters such as cooling fan speeds, power status, operating system (OS) status, hardware status, and so forth. The controller 410 can also include a system event log controller and/or storage for managing and maintaining events, alerts, and notifications received by the controller 410. For example, the controller 410 or a system event log controller can receive alerts or notifications from one or more devices and components, and maintain the alerts or notifications in a system event log storage component.

Flash memory 432 can be an electronic non-volatile computer storage medium or chip which can be used by the system 400 for storage and/or data transfer. The flash memory 432 can be electrically erased and/or reprogrammed. Flash memory 432 can include erasable programmable read-only memory (EPROM), electrically erasable programmable read-only memory (EEPROM), ROM, NVRAM, or complementary metal-oxide semiconductor (CMOS), for example. The flash memory 432 can store the firmware 434 executed by the system 400 when the system 400 is first powered on, along with a set of configurations specified for the firmware 434. The flash memory 432 can also store configurations used by the firmware 434.

The firmware 434 can include a Basic Input/Output System or its successors or equivalents, such as an Extensible Firmware Interface (EFI) or Unified Extensible Firmware Interface (UEFI). The firmware 434 can be loaded and executed as a sequence program each time the system 400 is started. The firmware 434 can recognize, initialize, and test hardware present in the system 400 based on the set of configurations. The firmware 434 can perform a self-test, such as a Power-on-Self-Test (POST), on the system 400. This self-test can test functionality of various hardware components such as hard disk drives, optical reading devices, cooling devices, memory modules, expansion cards, and the like. The firmware 434 can address and allocate an area in the memory 404, ROM 406, RAM 408, and/or storage device 412, to store an operating system (OS). The firmware 434 can load a boot loader and/or OS, and give control of the system 400 to the OS.

The firmware 434 of the system 400 can include a firmware configuration that defines how the firmware 434 controls various hardware components in the system 400. The firmware configuration can determine the order in which the various hardware components in the system 400 are started. The firmware 434 can provide an interface, such as an UEFI, that allows a variety of different parameters to be set, which can be different from parameters in a firmware default configuration. For example, a user (e.g., an administrator) can use the firmware 434 to specify clock and bus speeds; define what peripherals are attached to the system 400; set monitoring of health (e.g., fan speeds and CPU temperature limits); and/or provide a variety of other parameters that affect overall performance and power usage of the system 400.

While firmware 434 is illustrated as being stored in the flash memory 432, one of ordinary skill in the art will readily recognize that the firmware 434 can be stored in other memory components, such as memory 404 or ROM 406, for example. However, firmware 434 is illustrated as being stored in the flash memory 432 as a non-limiting example for explanation purposes.

System 400 can include one or more sensors 426. The one or more sensors 426 can include, for example, one or more temperature sensors, thermal sensors, oxygen sensors, chemical sensors, noise sensors, heat sensors, current sensors, voltage detectors, air flow sensors, flow sensors, infrared thermometers, heat flux sensors, thermometers, pyrometers, etc. The one or more sensors 426 can communicate with the processor, cache 428, flash memory 432, communications interface 424, memory 404, ROM 406, RAM 408, controller 410, and storage device 412, via the bus 402, for example. The one or more sensors 426 can also communicate with other components in the system via one or more different means, such as inter-integrated circuit (I2C), general purpose output (GPO), and the like.

FIG. 5 illustrates an example computer system 500 having a chipset architecture that can be used in executing the described method(s) or operations, and generating and displaying a graphical user interface (GUI). Computer system 500 can include computer hardware, software, and firmware that can be used to implement the disclosed technology. System 500 can include a processor 510, representative of any number of physically and/or logically distinct resources capable of executing software, firmware, and hardware configured to perform identified computations. Processor 510 can communicate with a chipset 502 that can control input to and output from processor 510. In this example, chipset 502 outputs information to output device 514, such as a display, and can read and write information to storage device 516, which can include magnetic media, and solid state media, for example. Chipset 502 can also read data from and write data to RAM 518. A bridge 504 for interfacing with a variety of user interface components 506, can be provided for interfacing with chipset 502. Such user interface components 506 can include a keyboard, a microphone, touch detection and processing circuitry, a pointing device, such as a mouse, and so on. In general, inputs to system 500 can come from any of a variety of sources, machine generated and/or human generated.

Chipset 502 can also interface with one or more communication interfaces 508 that can have different physical interfaces. Such communication interfaces can include interfaces for wired and wireless local area networks for broadband wireless networks, and for personal area networks. Some applications of the methods for generating, displaying, and using the GUI disclosed herein can include receiving ordered datasets over the physical interface or be generated by the machine itself by processor 510 analyzing data stored in storage 516 or 518. Further, the machine can receive inputs from a user via user interface components 506 and execute appropriate functions, such as browsing functions by interpreting these inputs using processor 510.

Moreover, chipset 502 can also communicate with firmware 512, which can be executed by the computer system 500 when powering on. The firmware 512 can recognize, initialize, and test hardware present in the computer system 500 based on a set of firmware configurations. The firmware 512 can perform a self-test, such as a POST, on the system 500. The self-test can test the functionality of the various hardware components 502-518. The firmware 512 can address and allocate an area in the memory 518 to store an OS. The firmware 512 can load a boot loader and/or OS, and give control of the system 500 to the OS. In some cases, the firmware 512 can communicate with the hardware components 502-510 and 514-518. Here, the firmware 512 can communicate with the hardware components 502-510 and 514-518 through the chipset 502 and/or through one or more other components. In some cases, the firmware 512 can communicate directly with the hardware components 502-510 and 514-518.

It can be appreciated that example systems 300, 400 and 500 can have more than one processor (e.g., 363, 430, 510) or be part of a group or cluster of computing devices networked together to provide greater processing capability.

For clarity of explanation, in some instances, the present disclosure may be presented as including functional blocks including devices, device components, steps, or routines in a method embodied in software, or combinations of hardware and software.

In some embodiments the computer-readable storage devices, mediums, and memories can include a cable or wireless signal containing a bit stream and the like. However, when mentioned, non-transitory computer-readable storage media expressly exclude media such as energy, carrier signals, electromagnetic waves, and signals per se.

Methods according to the above-described examples can be implemented using computer-executable instructions that are stored or otherwise available from computer readable media. Such instructions can include, for example, instructions and data which cause or otherwise configure a general purpose computer, special purpose computer, or special purpose processing device to perform a certain function or group of functions. Portions of computer resources used, can be accessible over a network. The computer executable instructions may be, for example, binaries and intermediate format instructions, such as assembly language, firmware, or source code. Examples of computer-readable media that may be used to store instructions, information used, and/or information created during methods according to the described examples, include magnetic or optical disks, flash memory, USB devices provided with non-volatile memory, networked storage devices, and so on.

Devices implementing methods according to these disclosures can include hardware, firmware and/or software, and can take any of a variety of form factors. Typical examples of such form factors include laptops, smart phones, small form factor personal computers, personal digital assistants, rack-mount devices, standalone devices, and so on. Functionality described herein also can be embodied in peripherals or add-in cards. Such functionality can also be implemented on a circuit board among different chips, or different processes executing in a single device, by way of further example.

The instructions, media for conveying such instructions, computing resources for executing them, and other structures for supporting such computing resources, are means for providing the functions described herein.

The various examples can be further implemented in a wide variety of operating environments, which in some cases can include one or more server computers, user computers or computing devices which can be used to operate any of a number of applications. User or client devices can include any of a number of general purpose personal computers, such as desktop or laptop computers running a standard operating system, as well as cellular, wireless, and handheld devices running mobile software, and capable of supporting a number of networking and messaging protocols. Such a system can also include a number of workstations running any of a variety of commercially-available operating systems, and other known applications for purposes such as development and database management. These devices can also include other electronic devices, such as dummy terminals, thin-clients, gaming systems and other devices capable of communicating via a network.

To the extent examples, or portions thereof, are implemented in hardware, the present disclosure can be implemented with any, or a combination of, the following technologies: a discrete logic circuit(s) having logic gates for implementing logic functions upon data signals; an application specific integrated circuit (ASIC) having appropriate combinational logic gates; programmable hardware such as a programmable gate array(s) (PGA); a field programmable gate array (FPGA); etc.

Most examples utilize at least one network that would be familiar to those skilled in the art for supporting communications using any of a variety of commercially-available protocols, such as TCP/IP, OSI, FTP, UPnP, NFS, CIFS, AppleTalk etc. The network can be, for example, a local area network, a wide-area network, a virtual private network, the Internet, an intranet, an extranet, a public switched telephone network, an infrared network, a wireless network, and any combination thereof.

Methods according to the above-described examples can be implemented using computer-executable instructions that are stored, or are otherwise available from computer readable media. Such instructions can include, for example, instructions and data which cause or otherwise configure a general purpose computer, special purpose computer, or special purpose processing device to perform a certain function or group of functions. Portions of computer resources used can be accessible over a network. The computer executable instructions can be, for example, binaries, intermediate format instructions such as assembly language, firmware, or source code. Examples of computer-readable media that can be used to store instructions, information used, and/or information created during methods according to described examples, include magnetic or optical disks, flash memory, USB devices provided with non-volatile memory, networked storage devices, and so on.

Devices implementing methods, according to these technologies, can include hardware, firmware and/or software, and can take any of a variety of form factors. Typical examples of such form factors include server computers, laptops, smart phones, small form factor personal computers, personal digital assistants, and so on. Functionality described herein also can be embodied in peripherals or add-in cards. Such functionality can also be implemented on a circuit board among different chips, or different processes executing in a single device, by way of further example.

In examples that utilize a Web server, the Web server can run any variety of server or mid-tier applications, including HTTP servers, FTP servers, CGI servers, data servers, Java servers, and business application servers. In response to requests from user devices, the Web server(s) can also be capable of executing programs or scripts. For example, the Web server can execute one or more Web applications, which can be implemented as one or more scripts or programs written in any programming language, such as Java®, C, C# or C++ or any scripting language, such as Perl, Python or TCL, as well as combinations thereof. The Web server(s) can also encompass database servers, including those commercially available on the open market.

The server system can include a variety of data stores and other memory and storage media, as discussed above. These can reside in a variety of locations, such as on a storage medium local to (and/or resident in) one or more of the computers, or remote from any or all of the computers across the network. In a particular set of examples, the information can reside in a storage-area network (SAN) familiar to those skilled in the art. Similarly, any necessary files for performing the functions attributed to the computers, servers or other network devices can be stored locally and/or remotely, as appropriate. Where a system includes computerized devices, each such device can include hardware elements that can be electrically coupled via a bus, the elements including, for example, at least one central processing unit (CPU), at least one input device (e.g., a mouse, keyboard, controller, touch-sensitive display element or keypad), and at least one output device (e.g., a display device, printer or speaker). Such a system can also include one or more storage devices, such as disk drives, optical storage devices and solid-state storage devices such as random access memory (RAM) or read-only memory (ROM), as well as removable media devices, memory cards, flash cards, etc.

Such devices can also include a computer-readable storage media reader, a communications device (e.g., a modem, a wireless or wired network card, an infrared computing device) and working memory, as described above. The computer-readable storage media reader can be connected with, or configured to receive, a computer-readable storage medium representing remote, local, fixed, and/or removable storage devices, as well as storage media for temporarily and/or more permanently containing, storing, transmitting and retrieving computer-readable information. The system and various devices will also typically include a number of software applications, modules, services or other elements located within at least one working memory device, including an operating system, and application programs such as a client application or Web browser. It should be appreciated that alternate examples can have numerous variations from those described above. For example, customized hardware might also be used and/or particular elements might be implemented in hardware, software (including portable software, such as applets), or both. Further, connection to other computing devices, such as network input/output devices, can be employed.

Storage media and computer readable media for containing code, or portions of code, can include any appropriate media known or used in the art, including storage media and computing media. The storage media and computing media can include, but are not limited to, volatile and non-volatile, removable and non-removable media for storage and/or transmission of data or information. The removable and non-removable media comprise RAM, ROM, EPROM, EEPROM, flash memory or other memory technology, CD-ROM, digital versatile disk (DVD) or other optical storage, magnetic cassettes, magnetic tape, magnetic disk storage or other magnetic storage devices or any other medium which can be used to store the desired information and which can be accessed by a system device. The data or information can include computer readable instructions, data structures, program modules, or other data. Based on the technology and teachings provided herein, a person of ordinary skill in the art will appreciate other ways and/or methods to implement the various aspects of the present disclosure.

The specification and drawings are, accordingly, to be regarded in an illustrative rather than a restrictive sense. It will, however, be evident that various modifications and changes can be made thereunto without departing from the broader spirit and scope of the patent application, as set forth in the claims.

## Claims

1. A computer-implemented method for dynamically adjusting a maximum fan duty in a server system (100), the method comprising:
powering on the server system (100);
receiving, from a Basic Input/Output System of the server system (100), bus interface information of a system board of the server system (100);
determining that there is no Rotation-Vibration-Issues sensitive device directly connected to the system board; and
setting a first maximum fan duty for one or more cooling fans of the server system (100).

2. The computer-implemented method of claim 1, further comprising:
determining that there is at least one Host Bus Adapter card or Redundant Array of Independent Disk card directly connected to the system board;
determining that there is at least one Rotation-Vibration-Issues sensitive device attached to the at least one Host Bus Adapter card or Redundant Array of Independent Disk card; and
setting a second maximum fan duty for the one or more cooling fans of the server system (100).

3. The computer-implemented method of claim 2, wherein the second maximum fan duty is smaller than the first maximum fan duty, and wherein the second maximum fan duty is a highest fan duty that is limited by Rotation-Vibration Issues of a corresponding type of the at least one Rotation-Vibration-Issues sensitive device.

4. The computer-implemented method of claim 2, further comprising:
determining that there is no Rotation-Vibration-Issues sensitive device attached to the at least one Host Bus Adapter card or Redundant Array of Independent Disk card; and
setting the first maximum fan duty for the one or more cooling fans of the server system (100).

5. The computer-implemented method of anyone of the claims 1 to 4, further comprising:
determining that there is at least one Rotation-Vibration-Issues sensitive device attached to the system board; and
setting a second maximum fan duty for the one or more cooling fans of the server system (100), wherein the second maximum fan duty is smaller than the first maximum fan duty.

6. The computer-implemented method of anyone of the claims 1 to 5, wherein determining that there is no HDD directly connected to the system board comprises determining whether a Rotation-Vibration-Issues sensitive device or a solid state drive is directed connected to the system board, based upon information defined in an operating system of the server system (100).

7. The computer-implemented method of anyone of the claims 1 to 6, wherein the system board is a field-replaceable unit that accommodates at least one Rotation-Vibration-Issues sensitive device and at least one solid state drive.

8. A system (100), wherein the system (100) comprises:
one or more cooling fans; and
a management controller configured to control the one or more cooling fans, the management controller operable to perform operations comprising:
powering on the system (100);
receiving, from a Basic Input/Output System of the system (100), bus interface information of a system board of the system (100);
determining that there is no Rotation-Vibration-Issues sensitive device directly connected to the system board; and
setting a first maximum fan duty for the one or more cooling fans of the system (100).

9. The system (100) of claim 8, wherein the management controller is further operable to perform operations comprising:
determining that there is at least one Host Bus Adapter card or Redundant Array of Independent Disk card directly connected to the system board.
determining that there is at least one Rotation-Vibration-Issues sensitive device attached to the at least one Host Bus Adapter card or Redundant Array of Independent Disk card; and
setting a second maximum fan duty for the one or more cooling fans of the system (100).

10. The system (100) of claim 9, wherein the second maximum fan duty is smaller than the first maximum fan duty, and wherein the second maximum fan duty is a highest fan duty that is limited by Rotation-Vibration-Issues of a corresponding type of the at least one Rotation-Vibration-Issues device.

11. The system (100) of anyone of the claims 8 to 10, wherein the management controller is further operable to perform operations comprising:
determining that there is at least one Rotation-Vibration-Issues sensitive device attached to the system board; and
setting a second maximum fan duty for the one or more cooling fans of the system (100), wherein the second maximum fan duty is smaller than the first maximum fan duty.

12. The system (100) of anyone of the claims 8 to 11, wherein determining that there is no Rotation-Vibration-Issues sensitive device directly connected to the system board, comprises determining whether a Rotation-Vibration-Issues sensitive device or a solid state drive is directly connected to the system board based upon information defined in an operating system of the system (100).

13. The system (100) of anyone of the claims 8 to 12, wherein the system board is a field-replaceable unit that accommodates at least one Rotation-Vibration-Issues sensitive device and at least one solid state drive.

14. A non-transitory computer-readable storage medium including instructions that, when executed by at least one processor of a system (100), cause the system (100) to perform operations, comprising:
powering on the system (100);
receiving, from a Basic Input/Output System of the system (100), bus interface information of a system board of the system (100);
determining that there is no Rotation-Vibration-Issues sensitive device directly connected to the system board; and
setting a first maximum fan duty for one or more cooling fans of the system (100).

## Amended claims

### Amended claims in accordance with Rule 137(2) EPC.

1. A computer-implemented method for dynamically adjusting a maximum fan duty in a server system (100), the method comprising:
(202) powering on the server system (100);
(204) receiving, from a Basic Input/Output System of the server system (100), bus interface information of a system board of the server system (100);
(206) determining whether there is a Rotation-Vibration-Issues sensitive device directly connected to the system board;
(208) if there is no Rotation-Vibration-Issues sensitive device directly connected to the system board, further determining whether there is at least one Host Bus Adapter card or Redundant Array of Independent Disk card directly connected to the system board;
(210) if there is no Host Bus Adapter card or Redundant Array of Independent Disk card directly connected to the system board, setting a first maximum fan duty for one or more cooling fans of the server system (100);
(212) if there is a Host Bus Adapter card or Redundant Array of Independent Disk card directly connected to the system board, further determining whether there is a Rotation-Vibration-Issues sensitive device attached to the Host Bus Adapter card or Redundant Array of Independent Disk card; and
(214) if there is the Rotation-Vibration-Issues sensitive device attached to the Host Bus Adapter card or the Redundant Array of Independent Disk card, setting a second maximum fan duty for the one or more cooling fans of the server system (100), wherein the second maximum fan duty is smaller than the first maximum fan duty.

2. The computer-implemented method of claim 1, wherein the second maximum fan duty is a highest fan duty that is limited by Rotation-Vibration Issues of a corresponding type of the at least one Rotation-Vibration-Issues sensitive device.

3. The computer-implemented method of claim 1 or 2, further comprising:
determining that there is no Rotation-Vibration-Issues sensitive device attached to the at least one Host Bus Adapter card or Redundant Array of Independent Disk card; and
setting the first maximum fan duty for the one or more cooling fans of the server system (100).

4. The computer-implemented method of anyone of the claims 1 to 3, further comprising:
determining that there is at least one Rotation-Vibration-Issues sensitive device attached to the system board; and
setting a second maximum fan duty for the one or more cooling fans of the server system (100), wherein the second maximum fan duty is smaller than the first maximum fan duty.

5. The computer-implemented method of anyone of the claims 1 to 4, wherein determining that there is no HDD directly connected to the system board comprises determining whether a Rotation-Vibration-Issues sensitive device or a solid state drive is directed connected to the system board, based upon information defined in an operating system of the server system (100).

6. The computer-implemented method of anyone of the claims 1 to 5, wherein the system board is a field-replaceable unit that accommodates at least one Rotation-Vibration-Issues sensitive device and at least one solid state drive.

7. A system (100), wherein the system (100) comprises:
one or more cooling fans; and
a management controller configured to control the one or more cooling fans, the management controller operable to perform operations comprising:
(202) powering on the system (100);
(204) receiving, from a Basic Input/Output System of the system (100), bus interface information of a system board of the system (100);
(206) determining whether there is a Rotation-Vibration-Issues sensitive device directly connected to the system board;
(208) if there is no Rotation-Vibration-Issues sensitive device directly connected to the system board, further determining whether there is at least one Host Bus Adapter card or Redundant Array of Independent Disk card directly connected to the system board;
(210) if there is no Host Bus Adapter card or Redundant Array of Independent Disk card directly connected to the system board, setting a first maximum fan duty for the one or more cooling fans of the system (100);
(212) if there is a Host Bus Adapter card or Redundant Array of Independent Disk card directly connected to the system board, further determining whether there is a Rotation-Vibration-Issues sensitive device attached to the Host Bus Adapter card or Redundant Array of Independent Disk card; and
(214) if there is the Rotation-Vibration-Issues sensitive device attached to the Host Bus Adapter card or the Redundant Array of Independent Disk card, setting a second maximum fan duty for the one or more cooling fans of the server system (100), wherein the second maximum fan duty is smaller than the first maximum fan duty.

8. The system (100) of claim 7, wherein the second maximum fan duty is a highest fan duty that is limited by Rotation-Vibration-Issues of a corresponding type of the at least one Rotation-Vibration-Issues device.

9. The system (100) of anyone of the claims 7 to 8, wherein the management controller is further operable to perform operations comprising:
determining that there is at least one Rotation-Vibration-Issues sensitive device attached to the system board; and
setting a second maximum fan duty for the one or more cooling fans of the system (100), wherein the second maximum fan duty is smaller than the first maximum fan duty.

10. The system (100) of anyone of the claims 7 to 9, wherein determining that there is no Rotation-Vibration-Issues sensitive device directly connected to the system board, comprises determining whether a Rotation-Vibration-Issues sensitive device or a solid state drive is directly connected to the system board based upon information defined in an operating system of the system (100).

11. The system (100) of anyone of the claims 7 to 10, wherein the system board is a field-replaceable unit that accommodates at least one Rotation-Vibration-Issues sensitive device and at least one solid state drive.

12. A non-transitory computer-readable storage medium including instructions that, when executed by at least one processor of a system (100), cause the system (100) to perform operations comprising:
(202) powering on the system (100);
(204) receiving, from a Basic Input/Output System of the system (100), bus interface information of a system board of the system (100);
(206) determining whether there is a Rotation-Vibration-Issues sensitive device directly connected to the system board;
(208) if there is no Rotation-Vibration-Issues sensitive device directly connected to the system board, further determining whether there is at least one Host Bus Adapter card or Redundant Array of Independent Disk card directly connected to the system board
(210) if there is no Host Bus Adapter card or Redundant Array of Independent Disk card directly connected to the system board, setting a first maximum fan duty for one or more cooling fans of the system (100);
(212) if there is a Host Bus Adapter card or Redundant Array of Independent Disk card directly connected to the system board, further determining whether there is a Rotation-Vibration-Issues sensitive device attached to the Host Bus Adapter card or Redundant Array of Independent Disk card; and
(214) if there is the Rotation-Vibration-Issues sensitive device attached to the Host Bus Adapter card or the Redundant Array of Independent Disk card, setting a second maximum fan duty for the one or more cooling fans of the server system (100), wherein the second maximum fan duty is smaller than the first maximum fan duty.
